# EUROPEAN PATENT APPLICATION

(11) **EP 1 760 787 A1**
(43) Date of publication of application: **07.03.2007**
(21) Application number: 05019153.5
(22) Date of filing: 02.09.2005
(51) Int. Cl.: H01L 27/146, G01T 1/36, H01L 31/115

(54) **An imaging device for single X-ray photon counting**

(71) Applicant: PAUL SCHERRER INSTITUT, 5232 Villigen PSI (CH)
(72) Inventor: Brönnimann, Christian, 5420 Ehrendingen (CH)
(74) Representative: Fischer, Michael

(57) **Abstract**

A photon-counting imaging device for single x-ray counting is disclosed, comprising:
a) an assembly of a number of photon-counting imaging modules (18) which are connected to generate a flat detector plane;
b) each photon counting imaging module (18) comprising:
c) an L-shaped support structure (2) being connectable with adjacent support structures (2);
d) a monolithic pixellated semiconductor detector layer (16) and a high gain, low noise readout unit being bump-bonded to the detector layer (16);
e) said detector layer (16) and said readout unit being sandwiched to the lower surface (12) of the horizontal leg (4) of the L-shaped support layer (2), wherein the detector layer (16) covers the complete lower surface (4) ;
f) an module control board (22) for data collection and controlling the readout unit; said module control board (22) being disposed on the inner surface (20) of the vertical leg (6) of the L-shaped support layer (2); and
g) said module control board (22) and said readout unit being connected via at least one opening (8) which is disposed in the horizontal leg (4) of the L-shaped support structure (2).

These features allow to build an imaging device having a large detector area comprising dead detector area only to an negligible extend at the contact lines of adjacent imaging modules since any electrical contact is achieved in a direction substantially vertically to the detector plane. By providing the contact openings in the horizontal legs of the L-shaped support any contact with the evaluation electronic can be achieved on the backplane of the dectector and readout unit assembly without deteoring the active detector area.

## Description

The invention relates to a photon-counting imaging device for single x-ray counting.

X-ray diffraction patterns are useful in the analysis of molecular structures, such as protein and virus molecules, and require photon counting imaging devices. Especially, protein and virus crystallography imposes stringent requirements on x-ray detectors, particularly where the x-ray source is high flux synchrotron radiation that enables an experiment to be done rapidly. Furthermore, an important and developing field is time-resolved diffraction experiments using synchrotron radiation, such as crystallography and/or powder diffraction analysis. Monitoring a time-dependent reaction in a sample, i.e. a crystal or a powder, can elucidate the time-dependent crystal/molecular changes that occur in a chemical reaction as well. High time resolution speed is often critical in such monitoring.

A suitable photon-counting imaging device has been disclosed in the international patent application WO 2004/064168. Said device comprises:
a) a layer of photosensitive material, i.e. semiconductor material;
b) a source of bias potential;
c) a source of threshold voltage supply;
d) an NxM array of photodetector diodes arranged in said layer of photosensitive material; each of said photodetector diodes having a bias potential interface and a diode output interface, said bias potential interface of each photodetector diode being connected to said bias potential;
e) an NxM array of high gain, low noise readout unit cells, one readout unit cell for each photodetector diode;
f) each readout unit cell comprising an input interface connected to said diode output interface, a high-gain voltage amplifying means comprising a comparator unit, a digital counter unit, comprising a digital counter, and a digital counter output interface connected in series, each digital counter unit counting an output signal of the comparator unit; said output signal is proportional to a number of electron/hole pairs generated by a photon in the respective photodetector diode,
g) a multiplexing means comprising a row select and a column select allowing to access each of the readout cell units, i.e. to read out the digital data as actually stored in the digital counter to the digital counter output interface;
h) each digital counter output interface connected to an output bus
i) said output bus being connected to a data processing means controlling the multiplexing means.

According to these measures, a photon counting imaging device is created having an architecture of the readout circuitry that allows to be tolerant with respect to a local defect of a detector diode and/or readout unit cell and that allow to control and redesign the program and/or the status of each detector diode and/or readout unit cell. As shown in Figure 5 of this document, a solid-state photon-counting imaging device is illustrated detecting the photon radiation over a comparably large flat area. The present architecture combine a number of sixteen pixel sensors being arranged on a first substantially flat support plate for building a sensor module, and a sensor module control board being arranged on a second substantially flat support plate hosting the electronic evaluation equipment, i.e. multiplexing means, data processing means, which follow the afore-mentioned electronic readout equipment. The first substantially flat support plate and the second substantially flat support plate are arranged under an angle of 90°. This measure allows to construct a plane or curved detector surface area (here not shown in the drawings) made from a number of sensor modules having the sensor module control boards oriented to the opposite side of its detector surface.

Unfortunately, this architecture is accompanied by a comparably large dead space with respect to the effective detector area which occurs at the margins of the dectector area in order to contact the detector area to the evaluation electronics. Further, in this document is silent with respect to the contact between the detector and the read out electronic and the evaluation electronics.

It is therefore the objective of the present invention to provide a photon-counting imaging device which offer a comparably large detector area in a flat geometry with minimal dead area.

This objective is achieved by a photon-counting imaging device for single x-ray counting, comprising:
a) an assembly of a number of photon-counting imaging modules which are connected to generate a flat detector plane;
b) each photon counting imaging module comprising:
c) an L-shaped support structure being connectable with adjacent support structures;
d) a monolithic pixellated semiconductor detector layer and a number of high gain, low noise readout units being bump-bonded to the detector layer;
e) said detector layer and said readout units being sandwiched to the lower surface of the horizontal leg of the L-shaped support structure, wherein the detector layer covers the complete lower surface;
f) an module control board for data collection and controlling the readout units; said module control board being disposed on the inner surface of the vertical leg of the L-shaped support structure; and
g) said module control board and said readout unit being connected via at least one opening which is disposed in the horizontal leg of the L-shaped support structure.

These features allow to build an imaging device having a large detector area comprising dead detector area only to an negligible extend at the contact lines of adjacent imaging modules since any electrical contact is achieved in a direction substantially vertically to the detector plane. By providing the contact openings in the horizontal legs of the L-shaped support any contact with the evaluation electronic can be achieved on the backplane of the dectector and readout unit assembly without deteoring the active detector area. It shall be mentioned that the terms "horizontal leg" and "vertical leg" are not meant to imply only a perpendicular orientation of the two legs relative to each other, but shall indicate in a broader sense that the angle between the horizontal leg and the vertical leg can range from 30 to 150°, preferably from 80 to 100°.

An extremely helpful embodiment with respect to the contact on the backplane of the detector area can be achieved, when a flex-print circuit is provided on the lower surface of the horizontal leg of the L-shaped support structure; said flex-print circuit being wire-bonded to the readout units. Additionally, the flex-print circuit may comprise at least one connector which is aligned with at least one opening. Therefore, on the flex-print all the signals are routed from the wire-bonding contact pads to, for example, two connectors, each having 50 contacts.

In order to fix the individual photon-counting imaging modules a separate frame is provided having separate holding means or recesses in which the L-shaped support structure of each module can be fixed. Additionally, the frame may comprise cooling means, such as a precision water-cooled frame which allows to transfer the heat from the readout unit and/or the evaluation electronic. Therefore, it is advantageous when the frame and/or the L-shaped support structure are made from metal, i.e. Aluminum.

Exemplary embodiments according to the present invention are shown by the accompanied drawings which depict in:
- Figure 1: a perspective view on the L-shaped support structure; and
- Figure 2: a top view on one photon-counting imaging module disposed in a support frame.

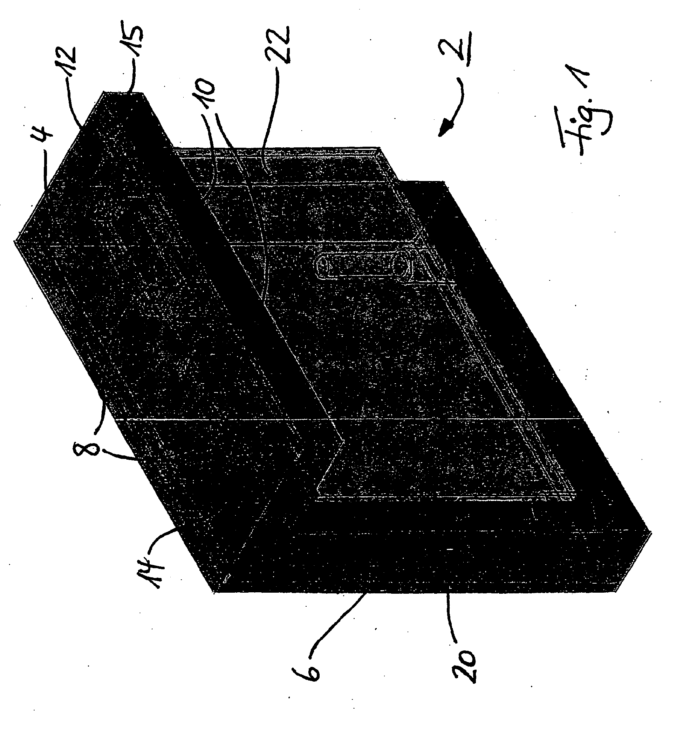

Figure 1 illustrates a L-shaped support structure 2 consisting of a precision aluminum shaped bar having a horizontal leg 4 and a vertical leg 6. In the horizontal leg 4 two openings 8 are provided for two through connectors 10. On the lower surface 12 of the horizontal leg 4 a flex-print circuit 14 which is glued to this lower surface. On he flex-print circuit 14 all signals are routed from a wire-bonded region 15 to the two through connectors 10. In this example, the through connectors 10 are on-edge 50 poles connectors. All the necessary signals for and/or from readout units which are bump-bonded to a detector layer 16 and wire-bonded to the flex-print circuit 14. Therefore, the readout units are sandwiched between the detector layer 16 and the flex-print circuit 14. In the present example, each module 18 comprises as the readout units 16 CMOS readout chips which are bump-bonded to the detector layer 16, which is in the present example a monolithic pixellated silicon layer. For more details, a monolithic pixellated silicon layer and the design of the CMOS readout chips has been described in the international patent application WO 2004/064168.

On the inner surface 20 of the horizontal leg 6 of the L-shaped support structure 2 a module control board 22 is mounted and comprises, for example, regulators, DACs and repeater circuits. The module control boards 22 is connected via the through connectors 10 to the readout units. Already from the design shown in Figure 1, it becomes apparent that several photon counting imaging modules 18 which each comprise the L-shaped support structure 2 can be easily combined to generate a flat detector area having almost no loss in detector area due to any contact regions which have been needed so far to contact both the readout units with the module board control 22.

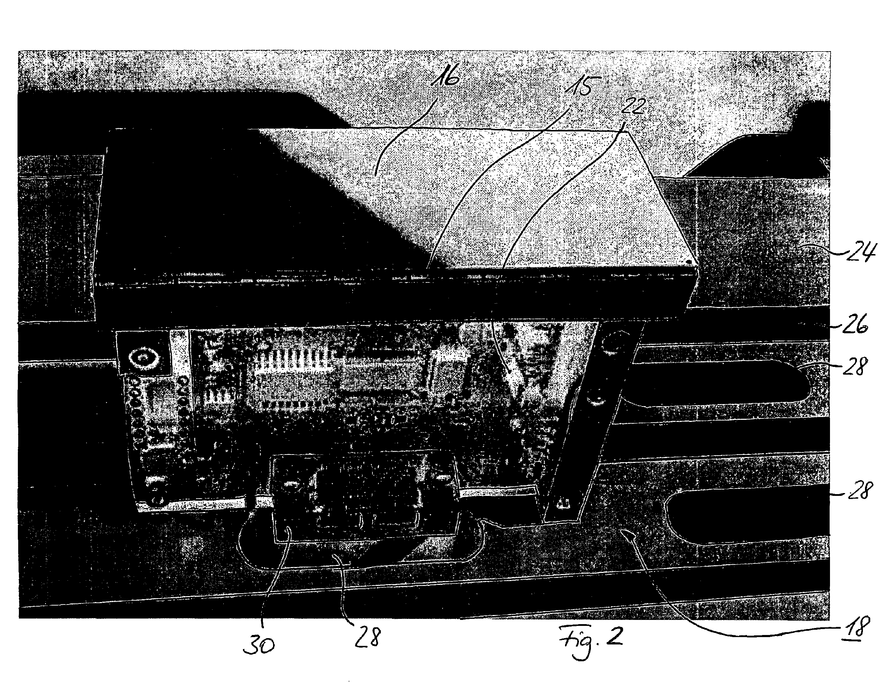

Figure 2 now illustrates a frame 24 which is used to support an assembly comprising a plurality of photon-counting imaging modules 18. The frame 24 comprises several equidistantial rails 26 in which the modules 18 can be mounted and fixed. Further, the frame 24 comprises openings 28 through which the contact for the module control boards 22 is achievable by respective connectors 30. In order to dispose the heat which is under operation generated by both the readout units and the module control boards, the frame 24 comprises cooling channels (not shown in detail) in order to get the frame 24 cooled and thereby pulling away the heat from the L-shaped support structures 2.

Accordingly, the frame 24 may comprise means to adjust the relative position of each individual module 18 in order to achieve an overall flatness the accumulated detector area and an even distribution of the positions of the individual modules 18.

According to the present invention, a comparably large detector plane can be generated which is almost continuous and has any ability for fast single photon counting since the readout units are disposed adjacent to the detector plane.

## Claims

1. A photon-counting imaging device for single x-ray counting, comprising:
a) an assembly of a number of photon-counting imaging modules (18) which are connected to generate a flat detector plane;
b) each photon counting imaging module (18) comprising:
c) an L-shaped support structure (2) being connectable with adjacent support structures (2);
d) a monolithic pixellated semiconductor detector layer (16) and a high gain, low noise readout unit being bump-bonded to the detector layer (16);
e) said detector layer (16) and said readout unit being sandwiched to the lower surface (12) of the horizontal leg (4) of the L-shaped support layer (2), wherein the detector layer (16) covers the complete lower surface (4);
f) an module control board (22) for data collection and controlling the readout unit; said module control board (22) being disposed on the inner surface (20) of the vertical leg (6) of the L-shaped support layer (2); and
g) said module control board (22) and said readout unit being connected via at least one opening (8) which is disposed in the horizontal leg (4)of the L-shaped support structure (2)

2. The photon-counting imaging device according to claim 1, wherein a flex-print circuit (14) is provided on the lower surface (12) of the horizontal leg (4) of the L-shaped support structure (2); said flex-print circuit (14) being wire-bonded to the readout units.

3. The photon-counting imaging device according to claim 1 or 2, wherein the flex-print circuit (14) comprises a connector (10) which is aligned with the at least one opening (8).

4. The photon-counting imaging device according to any of the preceding claims, wherein the individual photon-counting imaging modules (18) are supported by a frame (24) having separate holding means (26).

5. The photon-counting imaging device according to claim 4, wherein
the frame comprises means to adjust the relative position of each individual module in order to achieve an overall flatness the accumulated detector area and an even distribution of the positions of the individual modules.

6. The photon-counting imaging device according to claim 4 or 5 , wherein the frame (24) comprises cooling means.

7. The photon-counting imaging device according to any of the preceding claims, wherein the frame (24) and/or the L-shaped support structure (2) are made from metal, i.e. Aluminum, or other material having a high stiffness and/or a good heat conductivity, such glass fiber enforced composites.

8. The photon-counting imaging device according to any of the preceding claims, wherein
the angle between the vertical leg (6) and the horizontal leg (4) of the L-shaped support structure (2) is in the range of 30 to 150°, preferably in the range of 80 to 100°.
